# FASCICULE DE BREVET EUROPEEN

(11) **EP 4 394 775 B1**
(45) Date de publication et mention de la délivrance du brevet: **20.05.2026**
(21) Numéro de dépôt: 22216839.5
(22) Date de dépôt: 27.12.2022
(51) Int. Cl.: G11C 16/16, G11C 16/18

(54) **DISPOSITIF ET PROCÉDÉ D'EFFACEMENT DE DONNÉES AUTOMATISÉ**
VORRICHTUNG UND VERFAHREN ZUR AUTOMATISIERTEN DATENLÖSCHUNG
DEVICE AND METHOD FOR AUTOMATED DATA ERASURE

(43) Date de publication de la demande: 03.07.2024
(73) Titulaire: Uzzan, Lionel, 75014 Paris (FR)
(72) Inventeur: Uzzan, Lionel, 75014 Paris (FR)
(74) Mandataire: Gsmart

(56) Documents cités:
- JP-A- S5 975 496
- JP-B2- 7 033 246
- US-A- 4 393 479

## Description

La présente invention concerne le domaine des appareils électroniques contenant des mémoires non volatiles (NAND ou NOR), comme par exemple les smartphones ou tablettes ou tout type de dispositif contenant de telles mémoires. L'invention concerne en particulier l'effacement des données contenues dans de telles mémoires.

En effet, un problème dans ce domaine concerne l'effacement des données contenues dans ces mémoires, notamment dans le cas du reconditionnement ou recyclage de ces appareils, pour garantir aux utilisateurs de ces appareils que leurs données ne puissent pas être récupérées par des tiers sans leur accord. Classiquement, pour effacer les données dans ce type de mémoire, on réinitialise les bits en accédant à la mémoire par des moyens informatiques grâce à des portes logiques, ce qui est fastidieux et nécessite de démarrer l'appareil qui doit être au moins partiellement fonctionnel. Par exemple, lorsqu'un appareil n'est plus fonctionnel au point qu'il faille en réparer la carte mère et/ou les composants principaux pour pouvoir lancer une commande d'effacement logicielle, la solution préférée pour l'instant est de reléguer l'appareil pour destruction par broyage et/ou fonte, ce qui représente un gaspillage évident à de nombreux égards (avec des enjeux économiques et écologiques conséquents). De plus, lorsque ces appareils restent suffisamment fonctionnels pour un accès logiciel, un problème récurrent concerne le fait que les nombreux appareils du marché comportent des moyens de connexion et des systèmes d'exploitation qui sont très variables, ce qui impose une grande diversité de connecteurs et de logiciels d'accès aux données. Le temps nécessaire à l'effacement de données est donc conséquent et problématique. L'automatisation de l'effacement de données est donc difficilement envisageable dans l'état actuel de l'art antérieur. D'autre part, les types de mémoires contenues dans ces appareils possèdent des architectures matérielles diverses, plus ou moins performantes et résistantes, ce qui complexifie également l'effacement de données.

Il est connu de l'art antérieur, notamment des documents US4393479 et JPS5975496, des solutions qui concernent l'effacement de données dans des mémoires EPROM au cours de leur fabrication, mais ces solutions ne répondent pas aux problèmes liés à des mémoires programmables, notamment celles présentes dans des appareils électroniques variés comme dans la présente demande.

Dans ce contexte, la présente demande propose un dispositif permettant un effacement de données fiable et rapide, en évitant le plus possible la destruction inutile des appareils et préférentiellement de manière compatible avec l'automatisation de l'effacement de données d'appareils électroniques.

Ce but est atteint par un dispositif selon la revendication 1.

D'autres particularités et avantages d'un dispositif selon la présente invention sont détaillés dans les revendications 2 à 9.

Un autre but de la présente demande est de proposer un procédé permettant un effacement de données fiable et rapide, en évitant le plus possible la destruction inutile des appareils et préférentiellement de manière compatible avec l'automatisation de l'effacement de données d'appareils électroniques.

Ce but est atteint par un procédé selon la revendication 10.

D'autres particularités et avantages d'un procédé selon la présente invention sont détaillés dans les revendications 11 à 14.

D'autres particularités et avantages de la présente invention apparaîtront plus clairement à la lecture de la description de divers modes de réalisation ci-après, faite en référence aux dessins annexés, dans lesquels :
[Fig 1] la figure 1 représente une vue schématique du dispositif automatisé d'effacement de données selon divers modes de réalisation ;
[Fig 2] la figure 2 représente une vue schématique du dispositif automatisé d'effacement de données selon divers modes de réalisation comprenant un faisceau de rayons X inclinable;

La présente demande concerne un dispositif automatisé d'effacement de données stockées dans des mémoires (M) non volatiles d'appareils (A) électroniques, par exemple portables tels que des smartphones ou tablettes ou encore tout type d'appareil électronique ou dispositif de stockage de données contenant des mémoires non volatiles, par exemple de type « Flash ». Le terme « mémoires non volatiles », regroupe par exemple les mémoires de type NAND ou NOR (donc flash et/ou EEPROM) reposant sur la technologie des semiconducteurs (MOS, « metal-oxide semiconductors » selon la terminologie anglo-saxonne) utilisant des transistors à porte flottante piégeant un ou plusieurs électrons (technologies connues sous les acronymes de SLC, MLC ou TLC) dans des trappes de charge (ou cellules), agencées sous forme de grilles flottantes disposées en une ou plusieurs (technologie 3D NAND) couches, chaque électron correspondant à un bit de données enregistrable et effaçable à volonté. Classiquement, pour effacer les données dans ce type de mémoire, on réinitialise les bits en accédant à la mémoire par des moyens informatiques grâce à des portes logiques, tandis que la présente demande propose d'effacer les données plus rapidement sans nécessiter d'accès informatique à ce type de mémoire, grâce à l'utilisation de rayons X calibrés pour expulser les électrons piégés dans les trappes de charge. Pour cela, la présente invention propose une calibration de l'irradiation tenant compte de l'architecture des mémoires non volatiles. L'invention permet par exemple d'effacer rapidement des données, notamment des données personnelles, stockées dans des mémoires d'appareils ou dispositifs électroniques, par exemple portables tels que des smartphones ou tablettes ou tout autre dispositif intégrant ce type de mémoire (mémoires portables par exemples). Le problème de l'effacement de données revêt une importance particulière par rapport à la préservation de la confidentialité des données personnelles des utilisateurs (par exemple dans le contexte du RGPD) et notamment lorsque les appareils ou dispositifs de ces utilisateurs sont destinés à être reconditionnés ou recyclés. L'effacement des données est généralement fastidieux alors que la présente invention permet de réaliser facilement et rapidement cet effacement de données, ce qui fournit des avantages en termes de temps et de coût, quel que soit le devenir de l'appareil dont on souhaite effacer les données stockées dans sa mémoire non volatile. De plus, par exemple dans le cas d'un reconditionnement, cet effacement de données doit préférentiellement éviter d'endommager les autres composants de l'appareil et divers modes de réalisation de l'invention permettent de répondre à ce problème.

Le dispositif automatisé d'effacement de données selon divers modes de réalisation préférés de l'invention est caractérisé en ce qu'il comporte une cabine (1) d'irradiation comprenant au moins une source (S) de rayons X confinée dans une enceinte hermétique aux rayons X et apte à recevoir successivement une pluralité d'appareils (A) électroniques amenés dans la cabine (1) par un convoyeur (2) et identifiés au préalable par des moyens d'identification de chacun desdits appareils (A) pour reconnaître le type d'appareil (A) et/ou de mémoire (M) à irradier. Une telle cabine (1) imperméable aux rayons X est connue du domaine et nécessaire pour protéger les utilisateurs, notamment à cause des puissances d'irradiation utilisées pour la mise en œuvre de la présente invention. Le convoyeur (2) peut par exemple être un tapis roulant sur lequel sont disposés les appareils (A) à irradier successivement, par exemple après leur identification, comme détaillé ci-après. D'autre part, le dispositif comporte une unité de contrôle (CU) pilotant le convoyeur (2) et ladite source (S) de rayons X pour irradier chacun des appareils (A) électroniques avec une puissance et une durée contrôlées, en fonction de paramètres d'irradiation correspondants aux appareils (A) identifiés par les moyens d'identification, pour l'effacement des données contenues dans les mémoires (M) non volatiles desdits appareils (A) électroniques. La cabine (1) comporte donc une enceinte hermétique aux rayons X dans laquelle pénètrent les appareils (A) grâce au convoyeur, à travers d'au moins une porte (par exemple une seule porte si le convoyeur fait des aller-retours au travers d'une seule entrée-sortie de la cabine ou deux portes si le convoyeur traverse la cabine, de telles portes pouvant par exemple coulisser perpendiculairement au plan du convoyeur, par exemple verticalement) empêchant de préférence toute sortie des radiations hors de la cabine (1). Ces portes sont contrôlées par l'unité de contrôle (CU) lors de l'acheminement des appareils (A) devant la source (S) de rayons X. L'ouverture et la fermeture des portes sera donc contrôlée en fonction des temps d'irradiation des appareils (A) dans la cabine (1), soit individuellement appareil après appareil, soit par fournées de plusieurs appareils simultanément. Concernant l'irradiation et le pilotage de la source (S), la demanderesse de la présente demande a pu observer qu'il est nécessaire de contrôler à la fois la puissance et la durée d'irradiation des divers appareils (A) à cause de la nature des mémoires (M) et/ou des autres composants qu'ils contiennent, comme détaillé ci-après.

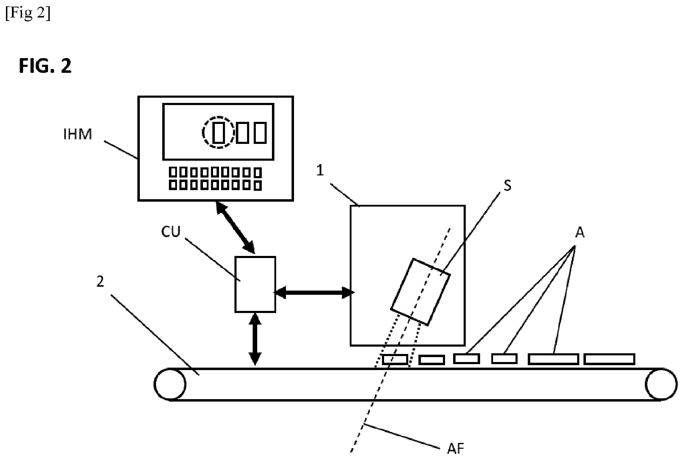

Dans divers modes de réalisation préférés de l'invention, l'unité de contrôle (CU) pilote la source de rayons X en contrôlant la puissance et la durée en fonction du type de mémoire (M) contenu dans lesdits appareils (A) électroniques. En effet, selon le type de mémoire (M) et leur architecture, la demanderesse de la présente demande a pu observer que la durée et la puissance d'irradiation devaient être ajustées afin de garantir un effacement des données. Par exemple, les mémoires « bon marché » (ou « bas de gamme ») sont souvent plus sensibles que les mémoires de plus haute qualité. D'autre part, certaines mémoires (M) sont fabriquées pour être protégées des rayonnements, notamment lors des passages des appareils (A) électroniques dans les scanners des aéroports. Ainsi, ces mémoires nécessitent une puissance et une durée plus importantes que celles non protégées. De plus, la position des mémoires (M) dans les appareils (A) est très variable, au point que certaines mémoires (M) sont protégées, sciemment ou par hasard, par la présence d'autres composants présents dans les appareils (A). Enfin, il existe des mémoires à structure tridimensionnelle, comme par exemple celles de la technologie connue sous le nom de 3D NAND, dans lesquelles les données sont stockées dans plus couches superposées, nécessitant une irradiation plus importante que les mémoires à couche unique. Il résulte de tous ces aspects que selon le modèle d'appareil (A) électronique dans lequel on souhaite effacer les données, il est nécessaire de connaître le type de mémoire et son emplacement pour piloter l'irradiation, afin d'en ajuster la puissance et la durée, ce qui influe sur la cadence du convoyeur (2) amenant les appareils (A) successifs dans la cabine (1). Il est donc nécessaire que l'unité de contrôle (CU) puisse piloter ces paramètres, grâce à la connaissance du type d'appareils (A) et/ou de mémoires (M) à irradier, par exemple grâce aux numéros de série des appareils (A). Cette connaissance pourra être fournie par un utilisateur saisissant les paramètres utilisés par l'unité de contrôle ou sélectionnant les paramètres à utiliser parmi une pluralité de paramètres enregistrés dans une mémoire de l'unité de contrôle (CU). De préférence, les divers appareils (A) d'un même type seront préparés à l'avance pour être acheminés à la suite par le convoyeur, afin que les paramètres et la cadence soient constants, mais l'invention prévoit de les faire varier en fonction du type d'appareils (A) préparés sur le convoyeur. Dans certains modes de réalisation, des moyens d'identification des appareils (A) électroniques seront prévus pour une reconnaissance automatique des appareils (A) et l'ajustement des paramètres d'irradiation par l'unité de contrôle grâce à une mémoire stockant les paramètres correspondants aux appareils (A) ainsi reconnus. Dans certains modes de réalisation, dont un exemple illustratif et non limitatif est représenté sur la figure 2, une interface homme-machine (IHM) est prévue pour permettre à un utilisateur de contrôler lesdits paramètres d'irradiation (grâce à des moyens de saisie ou sélection) et/ou d'en surveiller le bon déroulement (grâce à un affichage du foyer d'irradiation et des appareils qui s'y succèdent, via des moyens de capture d'image dans la cabine).

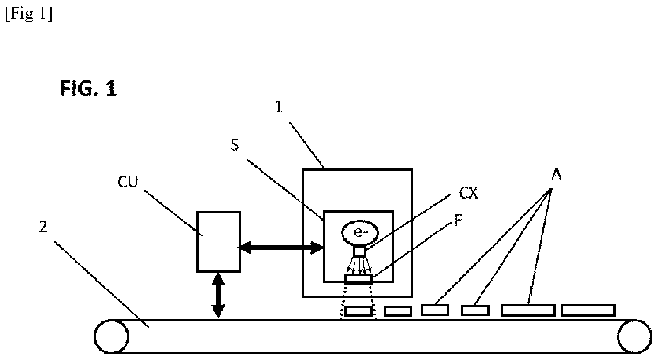

La figure 1 représente une vue schématique du dispositif automatisé d'effacement de données selon divers modes de réalisation préférés. Dans certains de ces modes de réalisation, la source de rayons X comporte une cible (CX) en Tungstène ou en Molybdène. Ce type de cible se montre particulièrement avantageux pour délivrer un faisceau de rayons X efficace pour l'effacement de données dans les mémoires (M) équipant les appareils (A) du marché. De plus, la demanderesse de la présente demande a pu observer que parmi les paramètres importants pour l'irradiation des mémoires (M) afin d'en effacer les données, la tension d'alimentation de la source était importante, mais également l'intensité cible de la source. Ainsi, la sélection d'une tension, d'une cible et d'une intensité cible est nécessaire pour obtenir les résultats souhaités. Par exemple, dans certains de ces modes de réalisation, l'unité de contrôle (CU) pilote la puissance d'irradiation en contrôlant une tension d'alimentation de la source de rayons X comprise entre 175 (cent soixante-quinze) et 300 (trois cents) kilovolts et une intensité cible de la source de rayons X comprise entre 250 (deux cent cinquante) et 900 (neuf cents) microampères, de préférence 350 (trois cent cinquante) à 750 (sept cent cinquante) microampères. D'autre part, la durée d'irradiation dépend fortement du type de mémoire (M) équipant les appareils (A) à irradier. Ainsi, dans l'unité de contrôle (CU) pilote la source de rayons X pour délivrer une irradiation pendant une durée comprise entre une et huit minutes, de préférence deux à cinq minutes.

Dans certains de ces modes de réalisation, la source de rayons X comporte une fenêtre (F) en Béryllium. Ce type de fenêtre présente l'avantage de filtrer les rayons à haute énergie et de laisser plutôt les basses énergies. L'utilisation d'une fenêtre en Béryllium de faible épaisseur s'est montrée particulièrement avantageuse pour obtenir une irradiation efficace pour l'effacement de données.

Dans certains de ces modes de réalisation, la distance entre ladite source (S) et le convoyeur acheminant les appareils est comprise entre deux et cinq centimètres, de préférence 2,5 à 4 centimètres (deux centimètres et demi à quatre centimètres). En effet, la demanderesse de la présente demande a pu observer que l'effacement était plus efficace lorsque la mémoire à effacer se trouvait séparée de la source (S) de seulement 2 à 3 centimètres.

Dans certains modes de réalisation, la source (S) génère un faisceau de rayons X irradiant lesdits appareils (A) selon un axe principal (AF) qui est incliné ou inclinable par rapport au plan du convoyeur. En effet, la demanderesse de la présente demande a pu observer que l'irradiation par un faisceau non perpendiculaire au plan du convoyeur permettait dans certains cas de faciliter l'effacement de données, notamment dans le cas de mémoires à structures tridimensionnelles. De plus, un tel faisceau incliné permet souvent d'éviter d'endommager les autres composants des appareils (A) électroniques dont on souhaite effacer le contenu des mémoires (M) ou au moins de limiter les risques de dommages. La figure 2 représente un exemple illustratif et non limitatif de tels modes de réalisation avec un axe principal (AF) de faisceau de rayons X incliné. L'unité de contrôle (CU) est alors configurée pour piloter l'inclinaison du faisceau, par exemple sous le contrôle d'un utilisateur utilisant l'interface homme-machine (IHM) ou sous le contrôle de paramètres pré-enregistrés dans une mémoire, en fonction de l'identification de l'appareil (A) à irradier. Il n'est pas nécessaire de décrire ici plus en détail le pilotage de l'inclinaison d'un faisceau de rayons X qui est largement connu de l'homme de métier. On comprendra à la lecture de la présente demande que l'inclinaison peut être d'un angle fixe et déterminé en fonction des angles préférés pour la plupart des appareils (A) connus ou pourra être variable et réglée par l'unité de contrôle (CU) pilotant un moteur inclinant la source et son faisceau, par exemple en fonction de l'identification des appareils (A) successifs amenés dans la cabine (1). Dans certains modes de réalisation, l'unité de contrôle (CU) contrôle également l'inclinaison de l'axe principal du faisceau en fonction du type d'appareil présent dans la cabine (1). Ainsi, l'axe principal est inclinable selon divers angles par rapport au plan du convoyeur, afin que le faisceau de rayons X puisse cibler les mémoires (M) de manière optimale selon leur architecture et/ou leur positionnement par rapport aux autres composants de l'appareil (A) qui les contiennent. Ainsi, ladite source (S) peut être montée sur au moins un moteur configuré pour le déplacement de la source (S) par rapport au convoyeur. Ce déplacement peut donc être piloté par l'unité de contrôle (CU) déterminant un foyer sur lequel doit être centré le faisceau de rayons X au sein de l'appareil ciblé à chaque instant.

On comprend que la présente invention concerne également un procédé d'effacement de données fiable et rapide, évitant le plus possible la destruction inutile des appareils et préférentiellement de manière compatible avec l'automatisation de l'effacement de données d'appareils électroniques. En effet, grâce aux paramètres identifiés par la demanderesse de la présente demande, l'invention fournit également un procédé efficace d'effacement de données permettant un gain de temps et une meilleure préservation des matériaux et composants des appareils (A) qui sont une grande source de pollution lorsqu'ils détruits.

L'invention concerne donc un procédé d'effacement de données stockées dans des mémoires (M) non volatiles d'appareils (A) électroniques, par exemple portables tels que des smartphones ou tablettes, caractérisé en ce qu'il comporte une identification de chacun desdits appareils (A) pour reconnaître le type d'appareil (A) et/ou de mémoire (M) à irradier, une détermination, par une unité de contrôle (CU), de paramètres d'irradiation correspondants aux appareils (A) identifiés par les moyens d'identification et une irradiation desdits appareils (A) électroniques par au moins une source (S) de rayons X confinée dans une enceinte hermétique aux rayons X d'une cabine (1) d'irradiation apte à recevoir successivement une pluralité d'appareils (A) électroniques amenés dans la cabine par un convoyeur (2), le convoyeur (2) et ladite source (S) de rayons X étant pilotés par ladite unité de contrôle (CU) en fonction desdits paramètres d'irradiation incluant la puissance et la durée d'irradiation pour l'effacement des données contenues dans la mémoire (M) non volatile desdits appareils (A) électronique. Les divers modes de réalisation du dispositif décrit dans la présente demande s'appliquent également au procédé qui pourra donc comporter diverses étapes et utiliser divers paramètres d'après les fonctionnalités décrites dans la présente demande.

La présente demande décrit diverses caractéristiques techniques et avantages en référence aux figures et/ou à divers modes de réalisation. L'homme de métier comprendra que les caractéristiques techniques d'un mode de réalisation donné peuvent en fait être combinées avec des caractéristiques d'un autre mode de réalisation à moins que l'inverse ne soit explicitement mentionné ou qu'il ne soit évident que ces caractéristiques sont incompatibles ou que la combinaison ne fournisse pas une solution à au moins un des problèmes techniques mentionnés dans la présente demande. De plus, les caractéristiques techniques décrites dans un mode de réalisation donné peuvent être isolées des autres caractéristiques de ce mode à moins que l'inverse ne soit explicitement mentionné.

Liste détaillée des références dans les figures :
M : mémoire non volatile
A : appareil électronique
1 : cabine
S : source de rayons X
2 : convoyeur
CU : unité de contrôle
AF : axe principal du faisceau de rayons X
CX : cible de la source de rayons X
F : fenêtre de la source de rayons X
IHM : interface Homme-machine

## Revendications

1. Dispositif automatisé d'effacement de données stockées dans des mémoires (M) non volatiles d'appareils (A) électroniques, par exemple portables tels que des smartphones ou tablettes, comportant une cabine (1) d'irradiation comprenant au moins une source (S) de rayons X confinée dans une enceinte hermétique aux rayons X et apte à recevoir successivement une pluralité d'appareils (A) électroniques amenés dans la cabine (1) par un convoyeur (2), des moyens d'identification de chacun desdits appareils (A) pour reconnaître le type d'appareil (A) et/ou de mémoire (M) à irradier, une unité de contrôle (CU) pilotant le convoyeur (2) et ladite source (S) de rayons X pour irradier chacun des appareils (A) électroniques avec une puissance et une durée contrôlées en fonction de paramètres d'irradiation correspondants aux appareils (A) identifiés par les moyens d'identification, pour l'effacement des données contenues dans les mémoires (M) non volatiles desdits appareils (A) électroniques.

2. Dispositif selon la revendication 1, **caractérisé en ce que** ladite unité de contrôle (CU) détermine, grâce auxdits moyens d'identification, l'emplacement et le type de mémoire des appareils à irradier et pilote ledit convoyeur (2) et ladite source (S) de rayons X en fonction de cet emplacement et ce type de mémoire déterminés.

3. Dispositif selon la revendication 2, **caractérisé en ce que** la source (S) génère un faisceau de rayons X irradiant lesdits appareils (A) selon un axe principal (AF) qui est incliné ou inclinable par rapport au plan du convoyeur, l'angle de cet axe principal (AF) étant déterminé par ladite unité de contrôle (CU) grâce auxdits moyens d'identification.

4. Dispositif selon la revendication 1 ou 2, **caractérisé en ce que** l'unité de contrôle (CU) pilote la source de rayons X en contrôlant la puissance et la durée en fonction du type de mémoire (M) contenu dans lesdits appareils (A) électroniques.

5. Dispositif selon l'une des revendications 1 à 3, **caractérisé en ce que** l'unité de contrôle (CU) pilote la puissance d'irradiation en contrôlant une tension d'alimentation de la source de rayons X comprise entre 175 et 300 kilovolts et une intensité cible de la source de rayons X comprise entre 250 et 900 microampères, de préférence 350 à 750 microampères.

6. Dispositif selon l'une des revendications précédentes, **caractérisé en ce que** l'unité de contrôle (CU) pilote la source de rayons X pour délivrer une irradiation pendant une durée comprise entre 1 et 8 minutes, de préférence 2 à 5 minutes.

7. Dispositif selon l'une des revendications précédentes, **caractérisé en ce que** la source de rayons X comporte une cible (CX) en Tungstène ou en Molybdène.

8. Dispositif selon l'une des revendications précédentes, **caractérisé en ce que** la source de rayons X comporte une fenêtre (F) en Béryllium.

9. Dispositif selon l'une des revendications précédentes, **caractérisé en ce que** la distance entre ladite source (S) et le convoyeur acheminant les appareils est comprise entre 2 et 5 centimètres, de préférence 2,5 à 4 centimètres.

10. Procédé d'effacement de données stockées dans des mémoires (M) non volatiles d'appareils (A) électroniques, par exemple portables tels que des smartphones ou tablettes, ledit procédé comportant :
- une identification de chacun desdits appareils (A) pour reconnaître le type d'appareil (A) et/ou de mémoire (M) à irradier,
- une détermination, par une unité de contrôle (CU), de paramètres d'irradiation correspondants aux appareils (A) identifiés par les moyens d'identification,
- une irradiation desdits appareils (A) électroniques par au moins une source (S) de rayons X confinée dans une enceinte hermétique aux rayons X d'une cabine (1) d'irradiation apte à recevoir successivement une pluralité d'appareils (A) électroniques amenés dans la cabine par un convoyeur (2), le convoyeur (2) et ladite source (S) de rayons X étant pilotés par ladite unité de contrôle (CU), en fonction desdits paramètres d'irradiation incluant la puissance et la durée d'irradiation pour l'effacement des données contenues dans la mémoire (M) non volatile desdits appareils (A) électronique.

11. Procédé selon la revendication 10, **caractérisé en ce que** lesdits paramètre d'irradiation incluent un axe principal (AF) d'un faisceau de rayons X généré par ladite source, cet axe (AF) étant incliné ou inclinable par rapport au plan du convoyeur et l'angle de cet axe principal (AF) étant déterminé par ladite unité de contrôle (CU) grâce auxdits moyens d'identification.

12. Procédé selon la revendication 10 ou 11, **caractérisé en ce que** l'unité de contrôle (CU) pilote la source de rayons X en contrôlant la puissance et la durée en fonction du type de mémoire (M) contenu dans lesdits appareils (A) électroniques.

13. Procédé selon l'une des revendications 10 à 12, **caractérisé en ce que** l'unité de contrôle (CU) pilote la puissance d'irradiation en contrôlant une tension d'alimentation de la source de rayons X comprise entre 175 et 300 kilovolts et une intensité cible de la source de rayons X comprise entre 250 et 900 microampères, de préférence 350 à 750 microampères.

14. Procédé selon l'une des revendications 10 à 13, **caractérisé en ce que** l'unité de contrôle (CU) pilote la source de rayons X pour délivrer une irradiation pendant une durée comprise entre 1 et 8 minutes, de préférence 2 à 5 minutes.

## Patentansprüche

1. Automatisierte Vorrichtung zum Löschen von Daten, die in nichtflüchtigen Speichern (M) von elektronischen Geräten (A), zum Beispiel tragbaren wie Smartphones oder Tablets, gespeichert sind, umfassend eine Bestrahlungskabine (1), die mindestens eine Röntgenstrahlenquelle (S) aufweist, die in einer für Röntgenstrahlen hermetisch dichten Kammer eingeschlossen ist, und in der Lage ist, nacheinander eine Vielzahl von elektronischen Geräten (A) aufzunehmen, die von einem Förderer (2) in die Kabine (1) gebracht werden, Mittel zur Identifizierung jedes der Geräte (A), um den Typ des zu bestrahlenden Geräts (A) und/oder Speichers (M) zu erkennen, eine Steuereinheit (CU), die den Förderer (2) und die Röntgenstrahlenquelle (S) steuert, um jedes der elektronischen Geräte (A) mit einer Leistung und Dauer, die in Abhängigkeit von Bestrahlungsparametern geregelt werden, die den von den Identifizierungsmitteln identifizierten Geräten (A) entsprechen, zum Löschen der in den nichtflüchtigen Speichern (M) der elektronischen Geräte (A) enthaltenen Daten zu bestrahlen.

2. Vorrichtung nach Anspruch 1, **dadurch gekennzeichnet, dass** die Steuereinheit (CU) mithilfe der Identifizierungsmittel den Ort und den Typ des Speichers der zu bestrahlenden Geräte bestimmt und den Förderer (2) und die Röntgenstrahlenquelle (S) in Abhängigkeit von diesem bestimmten Ort und Typ des Speichers steuert.

3. Vorrichtung nach Anspruch 2, **dadurch gekennzeichnet, dass** die Quelle (S) ein Röntgenstrahlenbündel erzeugt, das die Geräte (A) entlang einer Hauptachse (AF) bestrahlt, die in Bezug auf die Ebene des Förderers geneigt oder neigbar ist, wobei der Winkel dieser Hauptachse (AF) von der Steuereinheit (CU) mithilfe der Identifizierungsmittel bestimmt wird.

4. Vorrichtung nach Anspruch 1 oder 2, **dadurch gekennzeichnet, dass** die Steuereinheit (CU) die Röntgenstrahlenquelle steuert, indem sie die Leistung und die Dauer in Abhängigkeit von dem in den elektronischen Geräten (A) enthalten Typ des Speichers (M) regelt.

5. Vorrichtung nach einem der Ansprüche 1 bis 3, **dadurch gekennzeichnet, dass** die Steuereinheit (CU) die Bestrahlungsleistung steuert, indem sie eine Versorgungsspannung der Röntgenstrahlenquelle zwischen 175 und 300 Kilovolt und eine Zielstromstärke der Röntgenstrahlenquelle zwischen 250 und 900 Mikroampere, vorzugsweise 350 bis 750 Mikroampere, regelt.

6. Vorrichtung nach einem der vorhergehenden Ansprüche, **dadurch gekennzeichnet, dass** die Steuereinheit (CU) die Röntgenstrahlenquelle steuert, um eine Bestrahlung während einer Dauer zwischen 1 und 8 Minuten, vorzugsweise 2 bis 5 Minuten, abzugeben.

7. Vorrichtung nach einem der vorhergehenden Ansprüche, **dadurch gekennzeichnet, dass** die Röntgenstrahlenquelle ein Target (CX) aus Wolfram oder Molybdän umfasst.

8. Vorrichtung nach einem der vorhergehenden Ansprüche, **dadurch gekennzeichnet, dass** die Röntgenstrahlenquelle ein Fenster (F) aus Beryllium umfasst.

9. Vorrichtung nach einem der vorhergehenden Ansprüche, **dadurch gekennzeichnet, dass** der Abstand zwischen der Quelle (S) und dem Förderer, der die Geräte zuführt, zwischen 2 und 5 Zentimeter, vorzugsweise 2,5 bis 4 Zentimeter, beträgt.

10. Verfahren zum Löschen von Daten, die in nichtflüchtigen Speichern (M) von elektronischen Geräten (A) zum Beispiel tragbaren wie Smartphones oder Tablets, gespeichert sind, wobei das Verfahren Folgendes umfasst:
- eine Identifizierung jedes der Geräte (A), um den Typ des zu bestrahlenden Geräts (A) und/oder Speichers (M) zu erkennen,
- eine Bestimmung, durch eine Steuereinheit (CU), von Bestrahlungsparametern, die den Geräten (A) entsprechen, die von den Identifizierungsmitteln identifiziert wurden;
- eine Bestrahlung der elektronischen Geräte (A) durch mindestens eine Röntgenstrahlenquelle (S), die in einer für Röntgenstrahlen hermetisch dichten Kammer einer Bestrahlungskabine (1) eingeschlossen ist, die in der Lage ist, nacheinander eine Vielzahl von elektronischen Geräten (A) aufzunehmen, die von einem Förderer (2) in die Kabine gebracht werden, wobei der Förderer (2) und die Röntgenstrahlenquelle (S) von der Steuereinheit (CU) in Abhängigkeit von den Bestrahlungsparametern, die die Leistung und die Bestrahlungsdauer beinhalten, zum Löschung der in dem nichtflüchtigen Speicher (M) der elektronischen Geräte (A) enthaltenen Daten gesteuert werden.

11. Verfahren nach Anspruch 10, **dadurch gekennzeichnet, dass** die Bestrahlungsparameter eine Hauptachse (AF) eines von der Quelle erzeugten Röntgenstrahlenbündels beinhalten, wobei diese Achse (AF) in Bezug auf die Ebene des Förderers geneigt oder neigbar ist und der Winkel dieser Hauptachse (AF) von der Steuereinheit (CU) mithilfe der Identifizierungsmittel bestimmt wird.

12. Verfahren nach Anspruch 10 oder 11, **dadurch gekennzeichnet, dass** die Steuereinheit (CU) die Röntgenstrahlenquelle steuert, indem sie die Leistung und die Dauer in Abhängigkeit von dem in den elektronischen Geräten (A) enthaltenen Typ des Speichers (M) regelt.

13. Verfahren nach einem der Ansprüche 10 bis 12, **dadurch gekennzeichnet, dass** die Steuereinheit (CU) die Bestrahlungsleistung steuert, indem sie eine Versorgungsspannung der Röntgenstrahlenquelle zwischen 175 und 300 Kilovolt und eine Zielstromstärke der Röntgenstrahlenquelle zwischen 250 und 900 Mikroampere, vorzugsweise 350 bis 750 Mikroampere, regelt.

14. Verfahren nach einem der Ansprüche 10 bis 13, **dadurch gekennzeichnet, dass** die Steuereinheit (CU) die Röntgenstrahlenquelle steuert, um eine Bestrahlung während einer Dauer zwischen 1 und 8 Minuten, vorzugsweise 2 bis 5 Minuten, abzugeben.

## Claims

1. Automated device for erasure of data stored in non-volatiles memories (M) of electronic equipment (A), for example portable devices such as smartphones or tablets, comprising an irradiation unit (1) comprising at least one X-ray source (S) enclosed in a housing hermetic to X-rays and able to receive a plurality of electronic devices (A) fed into the unit (1) successively by a conveyor (2), means of identification of each of the said devices (A) in order to recognize the type of device (A) and/or of memory (M) to be irradiated, a control unit (CU) controlling the conveyor (2) and the said source (S) of X-rays so as to irradiate each of the electronic devices (A) with a power and a duration controlled as a function of irradiation parameters corresponding to the devices (A) identified by the means of identification, for the erasure of the data contained in the non-volatile memories (M) of the said electronic devices (A).

2. Device according to Claim 1, **characterized in that** the said control unit (CU) determines, by virtue of the said means of identification, the location and the type of memory of the devices to be irradiated and controls the said conveyor (2) and the said X-ray source (S) as a function of this location and this type of memory determined.

3. Device according to Claim 2, **characterized in that** the source (S) generates a beam of X-rays irradiating the said devices (A) along a main axis (AF) which is tilted or tiltable with respect to the plane of the conveyor, the angle of this main axis (AF) being determined by the said control unit (CU) by virtue of the said means of identification.

4. Device according to either of Claims 1 and 2, **characterized in that** the control unit (CU) controls the X-ray source by controlling the power and the duration according to the type of memory (M) contained in the said electronic devices (A).

5. Device according to one of Claims 1 to 3, **characterized in that** the control unit (CU) controls the irradiation power by controlling a power supply voltage of the X-ray source in the range between 175 and 300 kilovolts and a target intensity of the X-ray source in the range between 250 and 900 microamps, preferably 350 to 750 microamps.

6. Device according to one of the preceding claims, **characterized in that** the control unit (CU) controls the X-ray source so as to deliver an irradiation over a duration in the range between 1 and 8 minutes, preferably 2 to 5 minutes.

7. Device according to one of the preceding claims, **characterized in that** the X-ray source comprises a target (CX) made of Tungsten or Molybdenum.

8. Device according to one of the preceding claims, **characterized in that** the X-ray source comprises a window (F) made of Beryllium.

9. Device according to one of the preceding claims, **characterized in that** the distance between the said source (S) and the conveyor transporting the devices is in the range between 2 and 5 centimetres, preferably 2.5 to 4 centimetres.

10. Method for erasing data stored in non-volatile memories (M) of electronic equipment (A), for example portable devices such as smartphones or tablets, the said method comprising:
- an identification of each of the said devices (A) in order to recognize the type of device (A) and/or of memory (M) to be irradiated,
- a determination, by a control unit (CU), of irradiation parameters corresponding to the devices (A) identified by the means of identification,
- an irradiation of the said electronic devices (A) by at least one X-ray source (S) enclosed within a housing hermetic to X-rays of an irradiation unit (1) able to successively receive a plurality of electronic devices (A) fed into the unit by a conveyor (2), the conveyor (2) and the said X-ray source (S) being controlled by the said control unit (CU), as a function of the said irradiation parameters including the power and the duration of irradiation for the erasure of the data contained in the non-volatile memory (M) of the said electronic devices (A).

11. Method according to Claim 10, **characterized in that** the said irradiation parameters include a main axis (AF) of a beam of X-rays generated by the said source, this axis (AF) being tilted or tiltable with respect to the plane of the conveyor and the angle of this main axis (AF) being determined by the said control unit (CU) by virtue of the said means of identification.

12. Method according to either of Claims 10 and 11, **characterized in that** the control unit (CU) controls the X-ray source by controlling the power and the duration according to the type of memory (M) contained in the said electronic devices (A).

13. Method according to one of Claims 10 to 12, **characterized in that** the control unit (CU) controls the irradiation power by controlling a power supply voltage of the X-ray source in the range between 175 and 300 kilovolts and a target intensity of the X-ray source in the range between 250 and 900 microamps, preferably 350 to 750 microamps.

14. Method according to one of Claims 10 to13, **characterized in that** the control unit (CU) controls the X-ray source so as to deliver an irradiation over a duration in the range between 1 and 8 minutes, preferably 2 to 5 minutes.
